**Europäisches Patentamt**

**European Patent Office**

**Office européen des brevets**

(19)

(11) Veröffentlichungsnummer: **0 150 366**
A2

(12) # EUROPÄISCHE PATENTANMELDUNG

(21) Anmeldenummer: **84115077.4**

(51) Int. Cl.⁴: **H 01 L 27/06**

(22) Anmeldetag: **10.12.84**

(30) Priorität: **31.01.84 DE 3403327**

(43) Veröffentlichungstag der Anmeldung: **07.08.85**
**Patentblatt 85/32**

(84) Benannte Vertragsstaaten: **AT CH DE FR GB IT LI NL**

(71) Anmelder: **Siemens Aktiengesellschaft, Berlin und München Wittelsbacherplatz 2, D-8000 München 2 (DE)**

(72) Erfinder: **Hödlmayr, Franz, Dipl.-Ing., Werinherstrasse 101, D-8000 München 90 (DE)**

(54) **Schaltungsanordnung zur Minimierung der Wirkung parasitärer Transistorfunktionselemente in integrierten bipolaren Halbleiterschaltkreisen.**

(57) Schaltungsanordnung zur Minimierung der Wirkung parasitärer Transistorfunktionselemente (12) in integrierten bipolaren Halbleiterschaltkreisen (1) mit aktiven Transistorfunktionselementen (11), bei der dem Eingang (4, 7) des aktiven Transistorfunktionselementes (11) eine pn-Diode (14, 15, 16) vorgeschaltet ist und bei der zwischen dem dem Eingang (4, 7) des aktiven Transistorfunktionselementes (12) abgewandten Anschluß der Vorschalt-pn-Diode (14, 15, 16) und dem Ausgang (3, 6) des aktiven Transistorfunktionselementes (11) eine pn-Diode (14, 15, 17) zur Vermeidung von dessen Sättigung liegt.

EP 0 150 366 A2

Siemens Aktiengesellschaft        Unser Zeichen
Berlin und München                VPA 84 P 1053 E

Schaltungsanordnung zur Minimierung der Wirkung parasitärer Transistorfunktionselemente in integrierten bipolaren Halbleiterschaltkreisen

Die vorliegende Erfindung betrifft eine Schaltungsanordnung zur Minimierung der Wirkung parasitärer Transistorfunktionselemente in integrierten bipolaren Halbleiterschaltkreisen gemäß dem Oberbegriff des Patentanspruches 1.

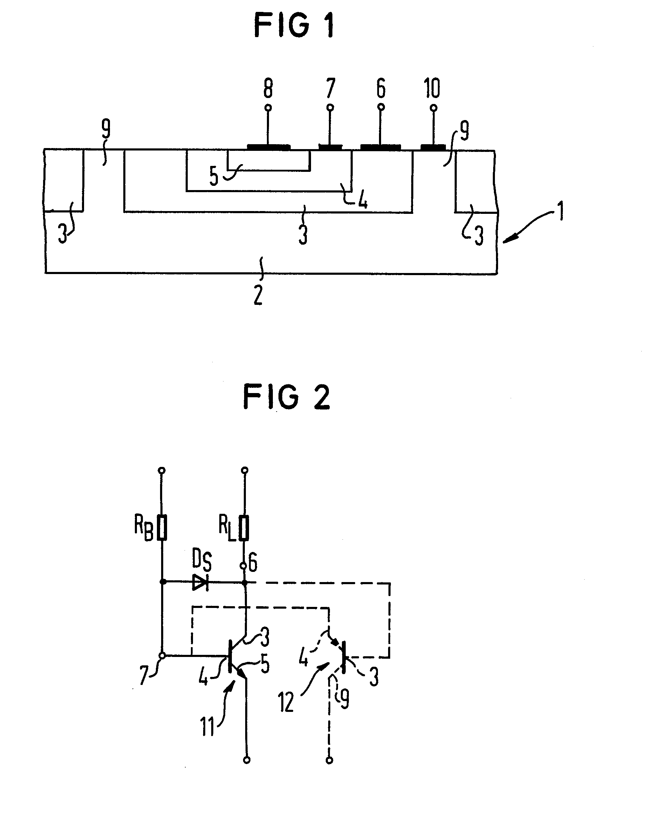

Der Aufbau eines Planartransistors in integrierten bipolaren Halbleiterschaltkreisen ist in Fig. 1 schematisch dargestellt. Bei einem derartigen integrierten Halbleiterschaltkreis 1 ist auf einem Substrat 2 des einen Leitungstyps (üblicherweise p-Leitungstyp) eine hochohmige epitaktische Schicht des anderen Leitungstyps (üblicherweise n-Leitungstyp) vorgesehen, die gleichzeitig den Kollektor eines npn-Transistors bildet, der weiterhin in der durch die epitaktische Schicht 3 gebildeten Kollektor-Zone eine Basis-Zone 4 und in dieser eine Emitter-Zone 5 enthält. Kollektor-, Basis- und Emitter-Zone sind in üblicher Weise kontaktiert, so daß sie über einen Kollektoranschluß 6, einen Basisanschluß 7 sowie einen Emitteranschluß 8 elektrisch zugänglich sind. Ein derartiges Transistorfunktionselement ist durch eine Isolations-Zone 9 vom Leitungstyp des Substrats gegen weitere nicht dargestellte Funktionselemente im integrierten Halbleiterschaltkreis durch eine pn-Übergangs-Isolation isoliert. Diese Isolations-Zone 9 kann ebenfalls in üblicher Weise kontaktiert sein, so daß das Substrat 2 über einen Anschluß 10 elektrisch zugänglich ist.

Lz 1 Dx / 30.01.1984

0150366

Durch die Basis-Zone 4, die Kollektor-Zone 3 sowie die Isolations-Zone 9 wird nun ein parasitäres Transistorfunktionselement gebildet, das bei Ausbildung des aktiven Transistorfunktionselementes 3, 4 und 5 als npn-Transistor ein pnp-Transistor ist.

Ein Ersatzbild einer derartigen Transistorkombination ist in Fig. 2 dargestellt, in der gleiche Elemente wie in Fig. 1 mit gleichen Bezugszeichen versehen sind. Im Ersatzbild nach Fig. 2 wird das durch die Zonen 3, 4 und 5 in Fig. 1 gebildete aktive Transistorelement durch einen Transistor 11 gebildet, während das durch die Zonen 4, 3 und 9 gebildete parasitäre laterale Transistorfunktionselement durch einen Transistor 12 gebildet wird. Um anzudeuten, daß der parasitäre Transistor 12 im integrierten Halbleiterschaltkreis nach Fig. 1 funktionsmäßig nicht erwünscht ist, ist er in Fig. 2 gestrichelt dargestellt.

Üblicherweise liegt im Kollektorzweig des aktiven Transistorfunktionselementes 11 ein Lastwiderstand $R_L$. Weiterhin wird das aktive Transistorfunktionselement 11 üblicherweise über einen Basisvorwiderstand $R_B$ angesteuert.

Im Betrieb einer derartigen durch das Transistorfunktionselement 11 gebildeten Transistorstufe nach Fig. 2 hat das parasitäre Transistorfunktionselement 12 insbesondere in dem Fall eine negative Wirkung, wenn das aktive Transistorfunktionselement 11 in den Bereich der Sättigung gesteuert wird. Dann liegt nämlich an der Basis 4 des aktiven Transistorfunktionselementes 11 eine Spannung in der Größenordnung von 750 mV, während das Potential am Kollektor 3 auf Werte bis zu 80 mV absinken kann. Das bedeutet, daß die Basis-Emitter-Strecke 3, 4 des parasitären Transistorfunktionselementes 12 in Durchlaßrichtung vorgespannt ist, so daß der in den Basisanschluß 7 eingespeiste Steuerstrom für das aktive Transistorfunktions-

0150366

element 11 über das in Durchlaßrichtung vorgespannte parasitäre Transistorfunktionselement 12 mindestens zu einem wesentlichen Teil in das Substrat abfließt.

Darüber hinaus hat die Sättigung eines aktiven Transistorfunktionselementes auch noch den weiteren Nachteil, daß die Schaltung langsam wird, weil eine zusätzliche Zeit erforderlich ist, um das aktive Transistorfunktionselement aus der Sättigung herauszusteuern.

Um die vorgenannten Nachteile zu vermeiden, ist bereits in Betracht gezogen worden, zwischen den Eingang und den Ausgang des aktiven Transistorfunktionselementes 11 - im vorliegenden Falle zwischen den Basisanschluß 7 und den Kollektoranschluß 6 gemäß Fig. 2 - eine Schottky-Diode $D_S$ mit einer derartigen Polarität zu schalten, daß die Sättigung des aktiven Transistorfunktionselementes 11 vermieden wird. Schottky-Dioden haben üblicherweise eine Schwellspannung in der Größenordnung von 400 mV. Wird das aktive Transistorfunktionselement 11 in den Bereich der Sättigung gesteuert und ergibt sich dabei zwischen Basis 4 und Kollektor 3 des aktiven Transistorfunktionselementes 11 eine Potentialdifferenz, die größer als die Schwellspannung der Schottky-Diode $D_S$ ist, so beginnt diese Diode zu leiten und führt einen Teil des Ansteuerstromes des aktiven Transistorfunktionselementes 11 über dessen Kollektor-Emitter-Strecke 3, 5 ab, so daß das aktive Transistorfunktionselement 11 nicht mehr in die Sättigung gelangen und das parasitäre Transistorfunktionselement 12 nicht mehr durchgesteuert werden kann. Damit sind dann die oben erläuterten Nachteile des Abfließens mindestens eines Teiles des Ansteuerstromes für das aktive Transistorfunktionselement 11 über das parasitäre Transistorfunktionselement 12 in das Substrat sowie die Verlangsamung der Schaltung aufgrund der Sättigung des aktiven Transistorfunktionselementes 11 vermieden.

Bei Ausbildung der zwischen Eingang und Ausgang des aktiven Transistorfunktionselementes 11 liegenden Diode als Schottky-Diode $D_S$ gemäß Fig. 2 ergibt sich jedoch der Nachteil, daß in einer üblichen Prozeßlinie für bipolare integrierte Schaltkreise zusätzliche technologische Schritte zur Realisierung der Schottky-Diode nötig sind und daß aufgrund voneinander abweichender Technologien für die Realisierng des bipolaren integrierten Schaltkreises einerseits und der Schottky-Diode andererseits die elektrischen Parameter für die Schottky-Diode schwer beherrschbar sind.

Der vorliegenden Erfindung liegt die Aufgabe zugrunde, eine Möglichleit zur schaltungstechnischen Realisierung der Vermeidung einer Sättigung eines aktiven Transistorfunktionselementes anzugeben, die technologisch mit üblichen Prozessen für die Herstellung bipolarer integrierter Halbleiterschaltkreise in einfacher Weise kompatibel ist.

Diese Aufgabe wird bei einer Schaltungsanordnung der eingangs genannten Art erfindungsgemäß durch die Merkmale des kennzeichnenden Teiles des Patentanspruches 1 gelöst.

Die erfindungsgemäße Schaltungsanordnung bietet mehrere Vorteile:
Erstens wird ein Sättigungszustand aktiver Transistorfunktionselemente vollkommen ausgeschlossen. Bei einer Lösung mit einer Schottky-Diode gelingt dies nur zum Teil. Darüber hinaus wurden aktive Transistorfunktionselemente auch weiter - um etwa 400 mV - aus dem Sättigungsbereich herausgehalten. Auch können parasitäre Transistorfunktionselemente weit weniger wirksam sein, wobei aktive Transistorfunktionselemente auch schneller arbeiten.

Zweitens ist die technologische Lösung einfacher, da pn-Dioden in der gleichen Technologie wie die übrigen Elemente der Schaltungsanordnung realisierbar sind.

0150366

Ausgestaltungen des Erfindungsgedankens sind in Unteransprüchen gekennzeichnet.

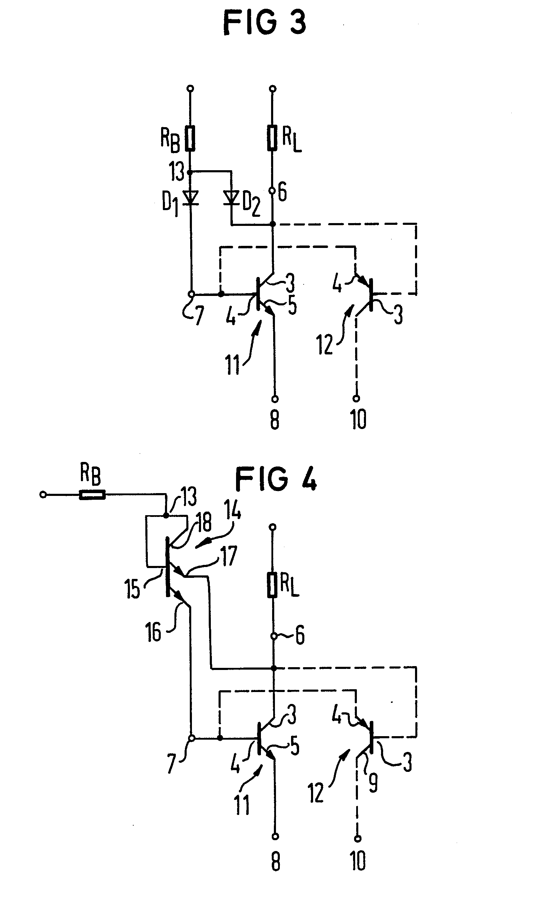

Die Erfindung wird im folgenden anhand von in den Fig. 3 und 4 der Zeichnung dargestellten Ausführungsbeispielen näher erläutert. Es zeigt:

Fig. 3 eine Ausführungsform der erfindungsgemäßen Schaltungsanordnung mit zwei pn-Dioden; und

Fig. 4 eine Ausführungsform der erfindungsgemäßen Schaltungsanordnung mit durch einen Mehremitter-Transistor realisierten Dioden.

In der Schaltungsanordnung nach Fig. 3, in der (ebenso wie in der Schaltungsanordnung nach Fig. 4) gleiche Teile wie in den Fig. 1 und 2 mit gleichen Bezugszeichen versehen sind, ist dem Eingang des aktiven Transistorfunktionselementes 11 (Basis 4 bzw. Basisanschluß 7) eine pn-Diode $D_1$ mit der gleichen Polungsrichtung wie der pn-Eingangskreis (Basis-Emitter-Strecke 4, 5) des aktiven Transistorfunktionselementes 11 vorgeschaltet. Weiterhin liegt zwischen einem Verbindungspunkt 13 des Basis-Vorwiderstandes $R_B$ und der pn-Diode $D_1$ eine weitere pn-Diode $D_2$ mit der gleichen Polungsrichtung wie die Diode $D_1$.

Die Wirkung der pn-Diode $D_2$ entspricht der Wirkung der Schottky-Diode $D_S$ gemäß Fig. 2. Da diese Diode jedoch als pn-Diode ausgebildet ist, kann sie in vorteilhafter Weise in der gleichen Prozeßtechnologie wie die aktiven Funktionselemente des integrierten Halbleiterschaltkreises nach Fig. 1 ausgebildet werden, so daß die oben angegebenen technologiebedingten Nachteile für Schottky-Dioden nicht auftreten.

Da jedoch diese Diode dann aus dem gleichen Material (in aller Regel Silicium) wie der integrierte Halbleiterschaltkreis insgesamt hergestellt ist, ergibt sich für diese Diode etwa die gleiche Schwellspannung wie die des Eingangskreises (Basis-Emitter-Strecke) des aktiven Transistorfunktionselementes 11. Würde daher die Diode $D_2$ allein vorhanden sein, so würde sie aufgrund dieser Schwellspannungsverhältnisse erst zu leiten beginnen, wenn das aktive Transistorfunktionselement 11 bereits in den Bereich seiner Sättigung gesteuert wäre. Das dem Sättigungsbereich des aktiven Transistorfunktionselementes 11 entsprechende Basispotential liegt nämlich in der Größenordnung von 850 mV, während die Schwellspannung der pn-Diode $D_2$ in der Größenordnung von 700 mV liegt. Bevor die pn-Diode $D_2$ daher zu leiten beginnen würde, wäre das aktive Transistorfunktionselement 11 schon in seine Sättigung gesteuert und damit sein Kollektorpotential so weit abgesenkt, daß das parasitäre Transistorfunktionselement 12 zu leiten beginnen und der Nachteil des Abfließens mindestens eines wesentlichen Teiles des Ansteuerstromes an der Basis in das Substrat auftreten würde.

Um dies zu vermeiden, ist erfindungsgemäß in Kombination mit der pn-Diode $D_2$ die Diode $D_1$ vorgesehen, so daß sich zwischen dem Punkt 13 und dem Emitter 5 bzw. dem Emitteranschluß 8 des aktiven Transistorfunktionselementes 11 die Summe zweier Schwellspannungen, nämlich die der Diode $D_1$ und die der Basis-Emitter-Strecke des aktiven Transistorfunktionselementes 11 ergibt. Da somit der Punkt 13 gegenüber der Basis 4 bzw. dem Basisanschluß 7 des aktiven Transistorelementes 11 um eine Schwellspannung, nämlich um die Schwellspannung der Diode $D_1$, angehoben ist, beginnt die Diode $D_2$ bereits bei Potentialen des Kollektors 3 des aktiven Transistorfunktionselementes 11 zu leiten, bei welchen das aktive Transistorfunktionselement 11 sicher außerhalb des Sättigungsbereiches betrieben wird.

Bei der Ausführungsform nach Fig. 4 ist anstelle der pn-Dioden $D_1$ und $D_2$ nach Fig. 3 ein Mehremitter-Transistor 14 vorgesehen, der zwei Emitter 16 und 17 besitzt und durch direkte Verbindung seiner Basis 15 und seines Kollektors 18 als Diode geschaltet ist. Zwischen dem Basisanschluß 7 und dem Kollektoranschluß 6 des aktiven Transistorfunktionselementes 11 liegt daher jeweils eine Diode, die durch die Basis-Emitter-Strecke 15, 16 bzw. 15, 17 des Mehremitter-Transistors 14 gebildet ist.

Die Funktionsweise der Schaltungsanordnung nach Fig. 4 entspricht derjenigen der Schaltungsanordnung nach Fig. 3.

3 Patentansprüche
4 Figuren

Patentansprüche

1. Schaltungsanordnung zur Minimierung der Wirkung parasitärer Transistorfunktionselemente (12) in integrierten bipolaren Halbleiterschaltkreisen (1) mit aktiven Transistorfunktionselementen (11), die im Halbleiterschaltkreis (1) durch Planartechnik realisiert sind und durch Sperrschichtisolation (9) von weiteren Funktionselementen im integrierten Schaltkreis (1) isoliert sind, bei der zwischen Eingang (4, 7) und Ausgang (3, 6) des aktiven Transistorfunktionselementes (11) eine Diode mit einer solchen Polung geschaltet ist, daß sie zu leiten beginnt, wenn das aktive Transistorfunktionselement (11) in den Sättigungsbereich gesteuert wird, d a d u r c h  g e k e n n z e i c h n e t , daß dem Eingang (4, 7) des aktiven Transistorfunktionselementes (11) eine pn-Diode ($D_1$; 14, 15, 16) mit der gleichen Polungsrichtung wie der pn-Eingangskreis (4, 5) des aktiven Transistorfunktionselementes (11) vorgeschaltet ist und daß die zwischen Eingang (4, 7) und Ausgang (3, 6) liegende Diode ($D_2$; 14, 15, 17) zwischen den vom Eingang (4, 7) des aktiven Transistorfunktionselementes (11) abgewandten Anschluß der Vorschalt-pn-Diode ($D_1$; 15, 16, 17) und den Ausgang (3, 6) des aktiven Transistorfunktionselementes (11) geschaltet ist.

2. Schaltungsanordnung nach Anspruch 1, d a d u r c h  g e k e n n z e i c h n e t , daß die pn-Dioden ($D_1$, $D_2$) durch jeweils eine gesonderte, gegebenenfalls mitintegrierte, Diode gebildet sind.

3. Schaltungsanordnung nach Anspruch 1, d a d u r c h  g e k e n n z e i c h n e t , daß die pn-Dioden durch einen als Diode geschalteten Mehremitter-Transistor (14) gebildet sind, bei dem jeweils eine Basis-Emitter-Strecke (15, 16 bzw. 15, 17) eine Diode bildet.

FIG 1

FIG 2

2/2

FIG 3

FIG 4

0150366